## Europäisches Patentamt
## European Patent Office
## Office européen des brevets

(19)

(11) Numéro de publication: **0 050 538**
**B1**

(12) # FASCICULE DE BREVET EUROPEEN

(45) Date de publication du fascicule du brevet:
**02.01.85**

(51) Int. Cl.³: **H 01 L 31/02,** H 01 L 25/04

(21) Numéro de dépôt: **81401478.3**

(22) Date de dépôt: **23.09.81**

(54) **Dispositif à cellules photovoltaïques pour la collecte d'énergie solaire et générateur solaire pourvu d'un tel dispositif.**

(30) Priorité: **09.10.80 FR 8021595**

(43) Date de publication de la demande:
**28.04.82 Bulletin 82/17**

(45) Mention de la délivrance du brevet:
**02.01.85 Bulletin 85/1**

(84) Etats contractants désignés:
**BE CH DE GB IT LI NL SE**

(56) Documents cités:
**DE - A - 2 825 582**
**GB - A - 1 503 903**
**US - A - 4 002 031**
**US - A - 4 020 399**
**US - A - 4 052 782**
**US - A - 4 211 581**

(73) Titulaire: **Société Nationale Industrielle Aérospatiale Société anonyme dite:, 37 Bld de Montmorency, F-75016 Paris (FR)**

(72) Inventeur: **Barkats, Gérard, 433 rue Janvier Pasero, F-06210 Mandelieu (FR)**
Inventeur: **Girard, Alain, 18, rue des Orangers, F-06170 Cros de Cagnes (FR)**
Inventeur: **Marchal, Jean, Mas Moghantarah Avenue des Jaisous, F-06530 Peymeinade (FR)**
Inventeur: **Morel, Charles, L'Oasis 22 bd Carnot, F-06110 Le Cannet (FR)**

(74) Mandataire: **Bonnetat, Christian et ai, Cabinet PROPI Conseils 23 rue de Léningrad, F-75008 Paris (FR)**

## Description

La présente invention concerne un dispositif à cellules photovoltaïques pour la collecte d'énergie solaire et un générateur solaire pourvu d'un tel dispositif.

On connaît déjà des générateurs solaires comportant un ensemble de cellules photovoltaïques transformant l'énergie solaire en énergie électrique. Dans certains de ces générateurs connus, on prévoit un dispositif de condensation du rayonnement solaire, tel qu'un miroir concave, mû par un mécanisme d'orientation asservi de façon à être constamment dirigé vers le soleil, ledit ensemble de cellules photovoltaïques étant disposé au foyer dudit dispositif de condensation et maintenu au moyen de bras fixés à la périphérie de celui-ci.

On sait par ailleurs que, pour pouvoir fonctionner correctement, les cellules photovoltaïques doivent être régulées en température. A cette fin, on prévoit des dispositifs, tels que des ailettes, permettant de dissiper la chaleur dégagée dans lesdites cellules photovoltaïques. Cependant, non seulement ces dispositifs ne sont pas totalement efficaces dans la régulation de la température desdites cellules photovoltaïques, mais encore ils sont lourds et encombrants. Il en résulte donc que la masse de la partie mobile du générateur est élevée et que l'asservissement en orientation du dispositif de condensation est difficile du fait de l'inertie importante et nécessite un mécanisme d'orientation puissant. De plus, par leur encombrement, des dispositifs connus de dissipation de chaleur portent une ombre importante sur le miroir, ce qui nuit au rendement du générateur. Par ailleurs, le document US-A-4 002 031 décrit un dispositif pour la collecte d'énergie solaire du type spécifié dans le préambule de la revendication 1 du présent brevet.

La présente invention a pour objet de remédier aux inconvénients mentionnés ci-dessus et de permettre la réalisation d'un ensemble focal de cellules photovoltaïques léger et peu encombrant, tout en permettant d'isoler électriquement les cellules et de maintenir une bonne conduction thermique.

A cette fin, selon l'invention, le dispositif pour la collecte d'énergie solaire, comprenant une première pluralité de cellules photovoltaïques, une seconde pluralité de conduits de chaleur fonctionnant par cyles évaporation-condensation d'un fluide et servant de supports auxdites cellules photovoltaïques, que sont fixées en contact thermique étroit sur lesdits conduits de chaleur, chaque conduit de chaleur comprenant au moins un bloc solide de matière thermiquement conductrice sur lequel au moins une partie d'une cellule photovoltaïque est fixée de façon à être en contact thermique étroit avec ledit bloc, et au moins un tube dont la paroi peut être traversée par la chaleur engendrée dans ladite cellule, ledit tube étant solidaire dudit bloc et en contact thermique avec lui, ladite seconde pluralité de conduits de chaleur étant enfermée au moins partiellement dans une enceinte traversée par un courant fluide de refroidissement, est caractérisé en ce que chaque tube est obturé à son extrémité opposée audit bloc pour définir une cavité close à l'intérieur de laquelle est enfermé ledit fluide évaporable et condensable.

De préférence, ledit bloc solide comporte un évidement prolongé extérieurement par ledit tube, ladite, cavité close étant alors définie par ledit évidement et le tube. Avantageusement, ledit tube et ladite cellule photovoltaïque sont disposés sur des faces opposées dudit bloc.

Lorsqu'au cours du fonctionnement de la cellule photovoltaïque, de la chaleur est dégagée dans celle-ci, ce dégagement de chaleur entraîne l'évaporation de la phase liquide du fluide et la phase vapeur qui en résulte se déplace vers l'extrémité du tube opposée au bloc. Tout le long du tube, la phase vapeur cède sa chaleur à celui-ci et se recondense.

La phase liquide condensée peut être ramenée vers le bloc par un revêtement intérieur du tube formant un réseau capillaire. Cependant, selon un mode de réalisation avantageux dans lequel le bloc est dirigé vers le bas et le tube vers le haut, le retour de la phase liquide condensée s'effectue sous l'action unique de la gravité, ce qui évite de prévoir tout dispositif de retour auxiliaire.

Le support selon l'invention peut être d'une seule pièce, par exemple obtenue par moulage. Il peut également être constitué par l'assemblage par soudure du bloc et du tube.

La présente invention concerne également un générateur solaire pourvu d'un dispositif pour la condensation de l'énergie solaire dans un plan focal, caractérisé en ce qu'il comporte un dispositif de collecte d'énergie solaire du type conforme à la présente invention, et disposé de façon que lesdites cellules photovoltaïques soient dirigées vers le bas dans ledit plan focal, lesdits conduits de chaleur étant alors dirigés vers le haut. Ce générateur peut être remarquable en ce que ledit dispositif de collecte d'énergie solaire est supporté par au moins un bras creux relié rigidement audit dispositif de condensation et en ce que la circulation dudit fluide de refroidissement traversant l'enceinte s'effectue à travers ledit bras.

On obtient ainsi un ensemble léger et peu encombrant, dans lequel les cellules photovoltaïques sont facilement régulées en température et qui convient particulièrement bien à un générateur à dispositif de condensation solaire et ensemble focal mobiles. De plus, outre l'énergie électrique produite, l'ensemble de cellules photovoltaïques selon l'invention fournit de la chaleur à un fluide, de préférence de l'eau, ce qui accroît son rendement.

Les figures du dessin annexé feront bien comprendre comment l'invention peut être réalisée.

La figure 1 est une vue en coupe longitudinale d'un support pour cellule photovoltaïque conforme à la présente invention.

La figure 2 illustre schématiquement un ensemble de cellules photovoltaïques, conforme à l'invention.

La figure 3 montre schématiquement en perspective un générateur solaire comportant l'ensemble de cellules photovoltaïques de la figure 2.

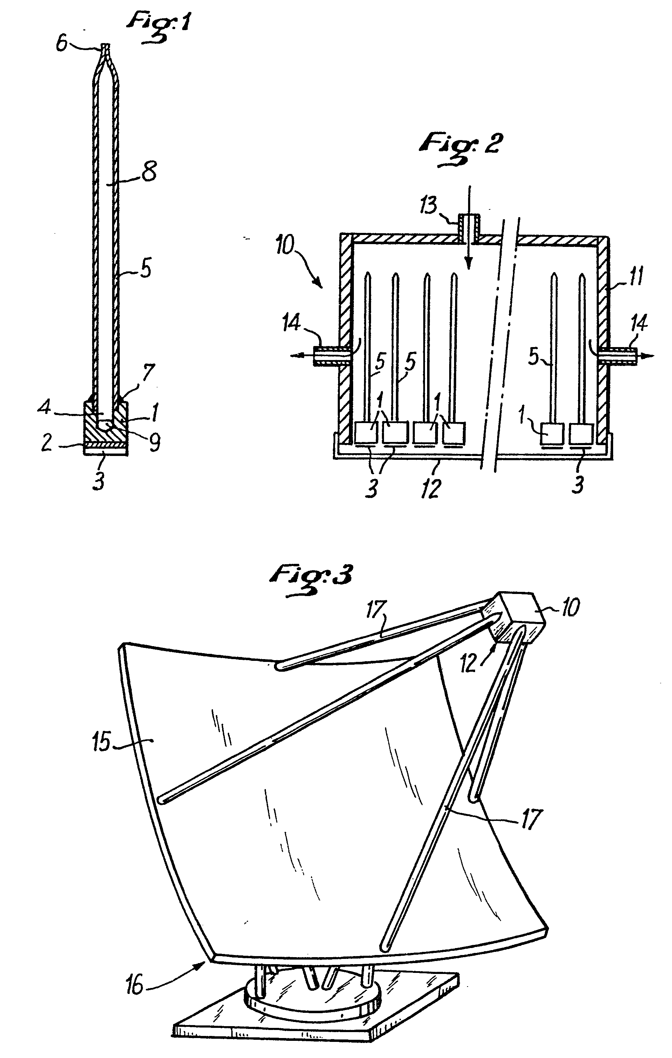

Le support, selon l'invention et montré par la figure 1, comporte un bloc 1 d'une matière thermiquement bonne conductrice, telle que le cuivre, de forme cubique par exemple. Sur une face dudit bloc 1 est fixée, par exemple au moyen d'une soudure à l'étain 2, une cellule photovoltaïque 3, de façon que celle-ci soit en contact thermique étroit avec le bloc 1.

Par ailleurs, dans ledit bloc 1 est pratiqué, à travers la face de celui-ci opposée à la cellule photovoltaïque 3 un évidement 4 dirigé vers celle-ci. L'évidement 4 est prolongé, à l'opposé du bloc 1, par un tube 5, également en une matière thermiquement bonne conductrice, telle que le cuivre. A son extrémité opposée au bloc 1, le tube 5 est obturé de façon étanche par un pincement 6.

Sur la figure 1, on a supposé que le tube 5 était rapporté au bloc 1, par encastrement dans l'évidement 4, puis soudure en 7. Il va de soi que le tube 5 et le bloc 1 pourraient constituer une seule pièce, obtenue par exemple par moulage, le pincement 6 étant réalisé par la suite.

Dans la cavité close 8, ainsi déterminée par le tube 5 et l'évidement 4, est disposée une petite quantité d'une substance volatile 9, telle qu'un alcool. Le volume de cette substance 9 peut par exemple correspondre au vingtième du volume de la cavité 8.

L'ensemble 1 à 9 est disposé de façon que la cellule photovoltaïque 3 soit dirigée vers le bas, de sorte que le tube 5 est dirigé vers le haut.

Ainsi, lorsque la cellule 3 reçoit un rayonnement approprié, d'une part elle engendre de l'énergie électrique qui est recueillie de manière non représentée sur les dessins et, d'autre part, elle est le siège d'un dégagement de chaleur. On sait que cette chaleur doit être évacuée de manière à contrôler la température de la cellule photovoltaïque 3 et à la maintenir dans une gamme correspondant au fonctionnement optimal de ladite cellule. Le processus d'évacuation de chaleur du support selon l'invention est le suivant.

La cellule 3 transmet sa chaleur au bloc 1 à travers la soudure 2, et de là au tube 5 par conduction. De plus, la chaleur reçue par le bloc 1 vaporise le liquide 9 et la vapeur ainsi formée se déplace dans la cavité 8 en direction du pincement 6. Lorsque la vapeur rencontre un point du tube 5 suffisamment froid, elle se condense et le condensat revient dans l'évidement 4, coulant par gravité le long des parois du tube 5. Le tube 5 reçoit donc la chaleur de la cellule 3 à la fois par conduction et par transmission par le fluide caloporteur.

La chaleur reçue par le tube 5 est ensuite prélevée de celui-ci par le milieu fluide (gaz ou liquide) entourant le tube 8.

On remarquera que le tube 5 peut ne pas être en une matière thermiquement bonne conductrice. En effet, il pourrait être en verre ou en matière synthétique, avec une paroi suffisamment mince pour pouvoir être traversée par le flux de chaleur avec faible écart de température. Dans ce cas, l'échange de chaleur s'effectuerait uniquement par l'intermédiaire du fluide 9.

Sur la figure 2, on a représenté une batterie 10 de cellules photovoltaïques 3, montées sur leurs supports 1, 5. Les ensembles 1, 3, 5 sont enfermés dans une enceinte étanche 11, pourvue d'une paroi transparente 12, à travers laquelle des cellules photovoltaïques 3 reçoivent le rayonnement dont l'énergie doit être transformée en électricité. De plus, l'enceinte étanche 11 est pourvue d'une entrée 13 d'un fluide froid, tel que de l'eau, et de sorties 14 dudit fluide réchauffé par prélèvement de la chaleur transmise, de la façon décrite ci-dessus, par les cellules 3 aux différents tubes 5. Ainsi, il est possible de récupérer la chaleur dégagée dans lesdites cellules photovoltaïques 3.

Bien entendu, les ensembles 1, 3, 5 sont revêtus, en tant que de besoin, par une pellicule électriquement isolante (non représentée), leur permettant d'être baignés par le fluide de refroidissement, sans que des liaisons électriques parasites s'établissent entre eux.

De plus, au lieu d'être enfermées dans l'enceinte 11, les cellules 3 pourraient être extérieures à celle-ci, l'étanchéité ayant lieu au niveau des blocs 1 ou des tubes 5. Dans ce cas, la paroi transparente 12 est sans objet.

La figure 3 illustre schématiquement un générateur solaire comportant un miroir concave 15, monté sur un mécanisme d'orientation 16. A la périphérie du miroir 15 sont prévus des bras convergents 17 supportant la batterie 10 de la figure 1, de façon que les cellules 3 se trouvent dans le plan focal dudit miroir. Le miroir 15 étant orienté vers le soleil, les cellules 3 sont dirigées vers le bas et les ensembles 1, 3, 5 fonctionnent de la façon décrite ci-dessus. De préférence, les conduits d'amenée et de départ de fluide (non représentés) reliés aux entrées et sorties 13 et 14 de la batterie 10 passent à travers certains des bras 17.

On voit ainsi que, grâce à l'invention, on obtient une batterie photovoltaïque légère et peu encombrante, n'influant pas de façon défavorable sur le mécanisme d'orientation 16, tout en permettant la récupération de l'énergie thermique engendrée par les cellules photovoltaïques 3.

**Revendications**

1. Dispositif pour la collecte d'énergie solaire, comprenant une première pluralité de cellules photovoltaïques (3), une seconde pluralité de conduits de chaleur fonctionnant par cycles évaporation-condensation d'un fluide et servant de supports auxdites cellules photovoltaïques, qui sont fixées en contact thermique étroit sur lesdits conduits de chaleur, chaque conduit de chaleur comprenant au moins un bloc solide (1) de matière thermiquement conductrice sur lequel au moins une partie d'une cellule photovoltaïque (3) est fixée de façon à être en contact thermique étroit avec ledit bloc (1), et au moins un tube (5) dont la paroi peut être traversée par la chaleur engendrée dans ladite cellule, ledit tube (5) étant solidaire dudit bloc (1) et en contact thermique avec lui, ladite seconde pluralité de conduits de chaleur (5) étant enfermée au moins partiellement dans une enceinte (11) traversée par un courant fluide de refroidissement, caractérisé en ce que chaque tube (5) est obturé à son extrémité opposée audit bloc (1) pour définir une cavité close (8) à l'intérieur de laquelle est enfermé ledit fluide évaporable et condensable.

2. Dispositif selon la revendication 1, caractérisé en ce que ledit bloc solide (1) comporte un évidement (4) prolongé extérieurement par ledit tube (5), ladite cavité close (8) étant définie par ledit évidement (4) et ledit tube (5).

3. Dispositif selon l'une quelconque des revendications 1 ou 2, caractérisé en ce que ledit tube (5) et ladite cellule photovoltaïque (3) sont disposés sur des faces opposées dudit bloc (1).

4. Dispositif selon la revendication 2, caractérisé en ce que ledit tube (5) est rapporté audit bloc (1).

5. Dispositif selon la revendication 2, caractérisé en ce que ledit tube (5) et ledit bloc (1) forment une seule pièce.

6. Générateur solaire, pourvu d'un dispositif (15) pour la condensation de l'énergie solaire dans un plan focal, caractérisé en ce qu'il comporte un dispositif de collecte d'énergie solaire du type spécifié sous la revendication 1, et disposé de façon que lesdites cellules photovoltaïques (3) soient dirigées vers le bas dans ledit plan focal, lesdits conduits de chaleur (5) étant alors dirigés vers le haut.

7. Générateur solaire selon la revendication 6, caractérisé en ce que ledit dispositif de collecte d'énergie solaire est supporté par au moins un bras creux (17) relié rigidement audit dispositif de condensation (15) et en ce que la circulation dudit fluide de refroidissement traversant l'enceinte (11) s'effectue à travers ledit bras (17).

**Patentansprüche**

1. Vorrichtung zum Sammeln von Sonnenenergie, bestehend aus einer ersten Anzahl photovoltaischer Zellen (3), einer zweiten Anzahl von Wärmeleitern, die nach der Verdunstungs-Kondensationsfolge einer Flüssigkeit arbeiten und den photovoltaischen Zellen als Halter dienen, die in engem Wärmekontakt an den Wärmeleitern befestigt sind, wobei jeder Wärmeleiter zumindest einen festen Block (1) aus wärmeleitendem Werkstoff, auf dem zumindest ein Teil einer photovoltaischen Zelle (3) derart befestigt ist, daß sie mit dem Block (1) in engem Wärmekontakt steht, und zumindest ein Rohr (5) aufweist, dessen Wand von der in der Zelle erzeugten Wärme durchdrungen werden kann und das mit dem Block (1) formschlüssig verbunden ist, sowie mit diesem in Wärmekontakt steht, wobei die zweite Anzahl der Wärmeleiter zumindest teilweise in einer Einfassung (11) eingeschlossen ist, die von einem Kühlungsmittelstrom durchquert wird, dadurch gekennzeichnet, daß das Rohr (5) an seinem dem Block (1) gegenüberliegenden Ende versperrt ist, um einen geschlossenen Hohlraum (8) zu bilden, in dessen Innern das verdunstungsfähige und kondensierbare Strömungsmittel eingeschlossen ist.

2. Vorrichtung nach Anspruch 1, dadurch gekennzeichnet, daß der feste Block (1) eine nach außen durch das Rohr . (5) verlängerte Ausnehmung (4) ist, wobei der geschlossene Hohlraum (8) umgrenzt wird von der Ausnehmung (4) und dem Rohr (5).

3. Vorrichtung nach einem der Ansprüche 1 oder 2, dadurch gekennzeichnet, daß das Rohr (5) und die photovoltaische Zelle (3) auf gegenüberliegenden Seiten des Blocks (1) angeordnet sind.

4. Vorrichtung nach Anspruch 2, dadurch gekennzeichnet, daß das Rohr (5) am Block (1) angebaut ist.

5. Vorrichtung nach Anspruch 2, dadurch gekennzeichnet, daß das Rohr (5) und der Block (1) aus einem Stück gefertigt sind.

6. Sonnengenerator mit einer Vorrichtung (15) zur Kondensierung von Sonnenenergie in einer Brennebene, dadurch gekennzeichnet, daß er einen Sonnenenergiesammler der unter Anspruch 1 beschriebenen Art aufweist und so angeordnet ist, daß die photovoltaischen Zellen (3) in der Brennebene nach unten gerichtet werden, wobei die Wärmeleiter (5) dann nach oben gerichtet sind.

7. Sonnengenerator nach Anspruch 6, dadurch gekennzeichnet, daß der Sonnenenergiesammler getragen wird von zumindest einem Hohlraum (17), der starr mit der Kondensierungsvorrichtung (15) verbunden ist, und daß der Umlauf der die Einfassung (11) durchquerenden Kühlungsflüssigkeit durch den Arm (17) hindurch erfolgt.

**Claims**

1. Solar energy collecting device, comprising a first plurality of photovoltaïc cells (3), a second plurality of heat conducts working by cycles of evaporation and condensation of a fluid and acting as supports for said photovoltaïc cells, which are fixed so as to be in close thermal contact with said heat conducts, each heat conduct comprising a solid block (1) of heat-conducting material on which at least a part of a photovoltaïc cell (3) is fixed so that it is in close thermal contact with said block (1), and at least a tube (5) whose wall may be traversed by the heat generated in said cell, said tube (5) being fast with said bloc (1) and in thermal contact therewith, said second plurality of heat conducts (5) being at least partially enclosed in a chamber (11) traversed by a flow of cooling fluid, characterized in that each tube (5) is obturated at its end opposite to said block (1) to define a closed cavity (8) inside which is enclosed said evaporable and condensable fluid.

2. The device of Claim 1, characterized in that said solid block (1) comprises a recess (4) extended outwardly by said tube (5), said closed cavity (8) then being formed by said recess (4) and the tube (5).

3. The device of anyone of Claims 1 or 2, characterized in that the tube (5) and the photovoltaïc cell (3) are disposed on opposite faces of said block (1).

4. The device of Claim 2, characterized in that the tube (5) is added to said block (1).

5. The device of Claim 2, characterized in that the tube (5) and said block (1) are in one piece.

6. Solar generator comprising a device (15) for condensing the solar energy in a focal plane, characterized in that it comprises a solar energy collecting device of the type as claimed in Claim 1, and arranged in such a way that photovoltaïc cells (3) are directed downwardly in said focal plane, said heat conducts (5) being directed upwardly.

7. The solar generator of Claim 6, characterized in that said solar energy collecting device is supported by at least one hollow arm (17) rigidly connected to the condensation device (15), and that the circulation of the cooling fluid flowing through chamber (11) is effected through said arm (17).

Fig. 1

Fig. 2

Fig. 3